# EUROPÄISCHE PATENTSCHRIFT

(11) **EP 0 487 011 B1**
(45) Veröffentlichungstag und Bekanntmachung des Hinweises auf die Patenterteilung: **26.07.1995**
(21) Anmeldenummer: 91119679.8
(22) Anmeldetag: 19.11.1991
(51) Int. Cl.: C25D 21/10

(54) **Verfahren zur Behandlung von plattenförmigem Gut in Galvanikanlagen oder dergleichen und zugehörige Anordnung**
Process and apparatus for the electrolytic treatment of platelike articles
Procédé et dispositif pour le traitement électrolytique d'articles en forme de plaques

(30) Priorität: 28.01.1991 DE 4102400; 23.11.1990 DE 4037215
(43) Veröffentlichungstag der Anmeldung: 27.05.1992
(73) Patentinhaber: ATOTECH Deutschland GmbH, 10553 Berlin (DE)
(72) Erfinder: Kosikowski, Thomas, W-8501 Burgthann (DE); Schneider, Reinhard, W-8501 Cadolzburg 2 (DE); Gute, Manfred, W-8500 Nürnberg 60 (DE)
(74) Vertreter: Effert, Udo, Dipl.-Ing.

(56) Entgegenhaltungen:
- DE-C- 496 541

## Beschreibung

Die Erfindung betrifft zunächst ein Behandlungsverfahren in Galvanikanlagen oder dergleichen Anlagen gemäß dem Oberbegriff des Anspruches 1. Hierbei ist bevorzugt an Anlagen zur Durchführung von Galvanisiervorgängen gedacht, aber auch an andere elektrolytische Behandlungen von Werkstücken, z.B. an eine Elektrophorese (lediglich zur sprachlichen Vereinfachung und nicht etwa als schutzrechtliche Einschränkung sind nachstehend nur noch die Ausdrücke: Galvanikanlagen, Galvanisiervorgänge, usw. verwendet). Dabei kann das Gut an seinem oberen Bereich am Warenträger angehängt werden, d.h. von diesem her frei senkrecht nach unten hängen. Auch wäre eine andere Halterung des Gutes möglich, wie an Traggestellen, die oberseitig am Warenträger befestigt sind und von diesem her senkrecht nach unten hängen, wobei das Gut mit jeder seiner Seitenkanten an je einem Traggestell gehalten ist. Diese Halterung des Gutes am jeweiligen Traggestell kann beispielsweise durch federnde Klammern erfolgen. Die im Oberbegriff genannte Warenbewegung hat den Zweck, den Austausch des Elektrolyts in der Grenzschicht zwischen der zu galvanisierenden Oberfläche und dem Galvanisierbad zu verbessern. Sofern im Gut Bohrungen vorgesehen sind, die quer zu seiner Plattenebene verlaufen (dabei ist insbesondere an die genannten Leiterplatten gedacht), wird das Gut bei der Galvanisierung in Richtung zu und von den Anoden bewegt. Damit wird auch in den Bohrungen der Leiterplatten ein Flüssigkeitsaustausch erreicht. Die außerdem im Oberbegriff angegebene Lufteinblaseinrichtung ist bei bekannten Anordnungen als Rohr ausgebildet, das mit einer Vielzahl von Luftaustrittsbohrungen versehen ist. Diese Lufteinblaseinrichtung ist an einem ortsfesten Teil der Anordnung, z.B. dem Badbehälter, fest angebracht, macht also mit ihren Luftaustritten die Warenbewegung nicht mit. Auch diese Lufteinblaseinrichtung dient dem o.g. Zweck, den Elektrolytaustausch in der Grenzschicht zu verbessern, um somit ein gleichmäßigeres Galvanisierungsergebnis zu erreichen und ferner die anwendbaren Stromdichten höher wählen zu können. Bei den vorbekannten Anordnungen ergeben sich Nachteile. Von der Lufteinblaseinrichtung in die Badflüssigkeit führende Luftaustritte lassen Luft ausströmen, die im Galvanisierbad nach oben steigt und dabei Teile der Badflüssigkeit mitnimmt. Die Strömungsgeschwindigkeit dieses Gemisches aus Bad und Luft ist senkrecht über diesen Luftaustrittsöffnungen der Lufteinblaseinrichtung am stärksten und nimmt seitlich davon mit immer größer werdendem seitlichen Abstand erheblich ab. Nun bringt aber die Warenbewegung das Gut, insbesondere die genannten Leiterplatten, aus seiner, bzw. ihrer symmetrisch zur Mitte des Luftaustrittes gelegenen Position in seitliche Bereiche, in denen, wie erläutert, die Geschwindigkeit des Gemisches aus Bad und Luft sich stark verringert hat. Hierdurch wird zum einen nachteiligerweise in diesen seitlichen Bereichen der von der Einblasung der Luft erwartete Effekt des Elektrolytaustausches in der Grenzschicht stark verringert. Außerdem ergeben sich hierdurch ungünstige mechanische Auswirkungen auf das Gut, da durch die unterschiedlichen Geschwindigkeiten des Gemisches aus Bad und Luft an der Vorderseite und an der Rückseite des Gutes Kräfte auftreten, welche das plattenförmige Gut in die Richtung ziehen, in der die größere Geschwindigkeit des Bad-Luftgemisches vorliegt. Das Gut, insbesondere dünne Leiterplatten, wird dabei ausgebeult und u.U. auch aus seinen Halterungen an einem Traggestell herausgezogen, zumindest darin bewegt. Sind die vorgenannten Ausbeulungen oder auch Verlagerungen der Leiterplatte und/oder ihr zumindest teilweises Herausziehen aus den Halterungen von Traggestellen einmal geschehen, so ist dies in der Regel irreversibel, d.h. die Leiterplatte oder ein ähnliches Gut kehrt nicht mehr in ihre ursprüngliche Lage zurück. Dies aber führt zu unterschiedlichen Galvanisierergebnissen auf der Vorder- und Rückseite des Gutes. Hinzu kommt, daß bei mit Bohrungen versehenen Leiterplatten das sog. Dicken-/Bohrungsverhältnis, also das Verhältnis der Dicke der Platte zum Durchmesser der darin befindlichen Querbohrungen, durch Neuentwicklungen der Technik immer größer gemacht wird. Dies aber bedingt für die Erzielung des notwendigen Flüssigkeitsaustausches in den Bohrungen eine Vergrößerung der Hublänge der Warenbewegung. Kam man früher mit einer Hublänge von ⁺ 15 mm aus, beträgt diese derzeit schon etwa ⁺ 35 mm. Je größer aber die Hublänge der Warenbewegung ist, desto mehr wirken sich die vorstehend erläuterten Nachteile zum Schlechten aus.

Aus der Literaturstelle JP 62-202099 A in: Patents Abstracts of Japan Sect. C, Vol. 12 (1988), Nr. 56 (C-477) ist ein Verfahren und eine dazugehörige Anordnung bekannt, bei welcher das im Bad hängende Gut selber keine Warenbewegung durchführt. Vielmehr soll alternierend über Düsen einmal Luft an der einen Seitenfläche (Vorderseite) und danach wiederum Luft an der anderen Seitenfläche (Rückseite) der Ware nach oben geführt werden. Durch einen Dreiwegehahn wird dabei von einem Gebläse her die Luft alternierend den zur Vorderseite gehörenden Austrittsdüsen einerseits und den zur Rückseite der Ware gehörenden Düsen andererseits zugeleitet. Gegenüber der nachstehend im einzelnen zu erläuternden Erfindung ist hiermit der entscheidende Nachteil gegeben, daß die Galvanisierzeit verlängert wird, weil in der Phase, in der keine Luft an einer Warenseite entlang strömt, die anwendbare Stromdichte wesentlich reduziert werden muß. Andernfalls entstehen qualitativ unbefriedigende Abscheidungen. Bei der Leiterplatten-Galvanisierung wird nicht nur in den Bohrungen der Leiterplatten abgeschieden, sondern auch auf deren Oberflächen (Vorder- und Rückseite). Bei der Anordnung und Verfahren nach der vorstehend genannten Literaturstelle müßte man zur Anpassung der Stromdichte an die unterschiedliche Lufteinblasung entweder eine seitenabhängige Steuerung des Galvanisierstromes anwenden, die aber sehr teuer und aufwendig ist, oder man muß, wie angegeben, die angewandte Stromdichte insgesamt reduzieren. Die Verwirbelung des Bades durch die ausströmende Luft alternativ an der einen und an der anderen Seite der Leiterplatte ergibt zwar eine den Galvanisiereffekt fördernde Bewegung des Elektrolyten durch die Bohrlöcher hindurch, ist aber mit den vorgenannten Nachteilen verbunden. Ferner besteht die Gefahr, daß Luftperlen sich in den Bohrungen festsetzen und nicht mehr entfernt werden, was zu Schäden in der Galvanisierschicht führen kann.

Beim Gegenstand von DD-PS 20 07 468 sind mit Bohrungen versehene Leiterplatten in einem Badbehälter zwischen zwei Trennwänden angeordnet. Von unten wird in den von den beiden Trennwänden begrenzten und die Leiterplatte aufnehmenden Raum Luft eingeblasen und zwar beiderseits der Leiterplatte. Die Leiterplatte selber wird quer zu ihrer Längsrichtung innerhalb dieses Raumes hin- und herbewegt. Da die ziemlich nahe beiderseits der Leiterplatte angeordneten Trennwände sich dabei nicht mit bewegen, soll hiermit ein Hindurchpumpen der Badflüssigkeit durch die Bohrungen der Leiterplatte erreicht werden. Abgesehen davon, daß vom Prinzip her die Anordnung nach dieser Literaturstelle nicht mehr zeigt als der bereits eingangs erläuterte Stand der Technik, ist sie für Galvanisierbäder nicht anwendbar, weil die Trennwände den Stromfluß unterbinden, d.h. der Einbau solcher Trennwände in der Galvanisierpraxis nicht möglich ist. Wie in Seite 1 Absatz 1 dieser Literaturstelle auch als Anwendungsgebiet beschrieben, ist die dortige Erfindung nur für den Bereich der Vor- und Nachbehandlung gedacht, also nicht für den elektrolytischen Prozeß selbst.

Beim Gegenstand von JP 62-33800 A in: Patents Abstracts of Japan, Sect. C, Vol. 11 (1987), Nr. 214 (C-434) handelt es sich um eine übliche Lufteinblaseinrichtung, bei der lediglich durch das Hineinragen eines Halterahmens für die zu behandelnden Leiterplatten zwischen zwei Lufteinblaserohre verhindert wird, daß die Leiterplatten durch die im Bad aufsteigende Luft aus ihrer senkrechten Lage heraus bewegt werden, was zu ungleichmäßigen Galvanisierergebnissen führen würde. Eine Warenbewegung gemäß dem Oberbegriff des Anspruches 1 ist auch bei dieser Literaturstelle nicht erwähnt.

DE-OS 38 24 260 zeigt nur ein Tauchverfahren zum elektrolytischen Beschichten von ruhenden Platten, insbesondere elektrischen Leiterplatten und eine dazugehörige Vorrichtung, wobei die Platten nicht durch eine Warenbewegung hin- und herbewegt werden, sondern lediglich unterhalb der Platten Luftaustritte vorgesehen sind, die einen Luftstrom an beiden Seitenflächen der Platte entlang nach oben strömen lassen.

Schließlich läßt der Gegenstand von US-PS 45 11 448 lediglich die Verwendung von Traggestellen erkennen, die beim Gegenstand der vorliegenden Erfindung als an sich bekannte Bauelemente mit erwähnt sind.

Der Erfindung liegt zunächst die Aufgaben- bzw. Problemstellung zugrunde, bei einem Verfahren zur Behandlung von plattenförmigem Gut, insbesondere von relativ dünnem, mit Querbohrungen versehenen Leiterplatten in Galvanikanlagen oder dergleichen Anlagen, wobei dem Gut in der Behandlungsflüssigkeit eine hin- und hergehende Warenbewegung erteilt wird und wobei eine Einblasung von Luft in die Behandlungsflüssigkeit vorgesehen ist, deren Luft beiderseits des Gutes nach oben strömt (Oberbegriff des Anspruches 1) die erläuterten ungünstigen Auswirkungen des Luftaustrittes der Lufteinblasung in die Behandlungsflüssigkeit auf das erzielte Galvanisierergebnis sowie die hierdurch bewirkten schädlichen mechanischen Einwirkungen auf das zu behandelnde Gut, insbesondere dünne Leiterplatten, zu verhindern.

Zur Lösung dieser Aufgaben- bzw. Problemstellung ist, ausgehend vom vorgenannten Oberbegriff des Anspruches 1, zunächst vorgesehen, daß der Luftaustrittsstrom in die Behandlungsflüssigkeit synchron und gleichgerichtet mit der Warenbewegung hin- und herbewegt wird. Sofern - was die Regel ist - die Mitte des Stromes des Luftaustrittes genau senkrecht unterhalb des jeweiligen Gutes positioniert ist, befindet sich somit das zu behandelnde Gut während der gesamten Warenbewegung immer in der Mittellage zum Luftaustrittsstrom der Lufteinblaseinrichtung und damit in der Mitte des vom Luftaustritt ständig an beiden Seiten der Ware nach oben gerichteten Stromes aus Luft und davon mitgerissener Badflüssigkeit. Die Erfindung koppelt also die Bewegung des Gutes durch den Warenträger mit einer synchron und gleichgerichtet dazu verlaufenden Bewegung eines beiderseits des Gutes vorhandenen, nach oben gerichteten Luftstromes. Damit strömt der Luft-Badstrom in gleicher Stärke an der Vorderseite und Rückseite des Gutes nach, wobei er unmittelbar an der Vorderseite und an der Rückseite seine maximale Geschwindigkeit aufweist. Dies hat einen optimalen Elektrolytaustausch zur Folge. Außerdem werden hiermit auf das plattenförmige Gut an deren Vorder- und Rückseite gleiche Kräfte ausgeübt, d.h. es besteht nicht die Gefahr der Ausbeulung oder Verlagerung des Gutes (was insbesondere bei Platten geschehen kann, die frei vom Warenträger her nach unten hängen). Auch besteht nicht die Gefahr, daß das Gut aus Halterungen von Traggestellen herausgerissen oder zumindest dazu verschoben wird.

Die Merkmale des Verfahrensanspruches 2 berücksichtigen, insbesondere bei einer größeren Länge der zu behandelnden Platten oder dergleichen, den Umstand, daß der aufsteigende Strom aus Luft und Badflüssigkeit eine gewisse Zeit braucht, um entlang der Platte oder dergleichen nach oben zu kommen. Wenn es angestrebt ist, kann man durch diese Voreilung die Intensität des Luftstromes auf einer Seite der Ware (Platte) etwas größer machen als auf der anderen Seite. Dies hat die Wirkung, daß aufgrund des entstehenden Soges noch mehr an Badflüssigkeit durch die Bohrungen hindurchgezogen wird.

Der Erfindung liegt ferner die Aufgaben- und Problemstellung zugrunde, Anordnungen zur Durchführung des Verfahrens nach Anspruch 1 oder 2 zu schaffen, mit denen zum einen der angestrebte Effekt erreicht wird und zum andern hierdurch gegenüber dem Stand der Technik keine wesentlichen Mehraufwendungen und größere Herstellungskosten anfallen.

Zur Lösung der vorgenannten Aufgabe ist, ausgehend von einer Anordnung in Galvanikanlagen oder dergleichen Anlagen mit einem Warenträger, an dem das zu behandelnde, plattenförmige Gut, insbesondere relativ dünne, mit Querbohrungen versehene Leiterplatten, lösbar angebracht ist und sich in senkrechter Lage im Behandlungsbad befindet, wobei über den Warenträger dem Gut eine hin- und hergehende Warenbewegung vermittelt wird, deren Bewegungsrichtung senkrecht zur Plattenebene des Gutes verläuft, und wobei unterhalb des jeweiligen Gutes eine Lufteinblaseeinrichtung vorgesehen ist, derart, daß von Luftaustritten der Lufteinblasung her Luft durch die Behandlungsflüssigkeit beiderseits des Gutes nach oben strömt (Oberbegriff des Anspruches 3) zunächst vorgesehen, daß der Luftaustritt der Lufteinblaseinrichtung mit einer Vorrichtung in Verbindung steht, die ihm eine synchron und gleichgerichtet mit der Warenbewegung verlaufende Hin- und Herbewegung, oder eine hin- und hergehende Verschwenkung vermittelt (Kennzeichen des Anspruches 3). Jede der hiermit angegebenen Möglichkeiten vermittelt dem Luftaustritt synchron zur Warenbewegung eine Verlagerung oder Verschwenkung in der jeweiligen Richtung der Warenbewegung und damit die angestrebte Koordinierung von Luftaustritt und Warenbewegung mit dem Effekt, daß ein Luftstrom ständig, d.h. während der gesamten Warenbewegung, beiderseits des Gutes nach oben strömt. Die dazu erforderlichen konstruktiven Mehraufwendungen sind gering. Zu dem bereits erläuterten funktionellen Vorteil kommt dieser Vorteil noch hinzu.

Gemäß Anspruch 4 kann ein eigener Antrieb für die Bewegung oder Verschwenkung des Luftaustrittes vorgesehen sein. Dies ermöglicht derartige Steuerungen ohne auf eine Verbindung oder Koppelung mit der Warenbewegung bzw. deren Antrieb selber angewiesen zu sein. Z.B. wird hierdurch eine voreilende Bewegung oder Verschwenkung des Luftaustrittes ermöglicht.

Gemäß Anspruch 5 ist sowohl eine mechanische Koppelung oder Verbindung der Luftaustritte mit der Lufteinblaseinrichtung möglich, als auch eine Bewegung der Luftaustritte, die von der Lufteinblaseinrichtung unabhängig ist, die z.B. fix an der Anordnung angebracht sein kann.

Eine konstruktiv sehr einfache sowie robuste Ausführung der Erfindung ist Gegenstand des Anspruches 6. Aufgrund der mechanischen Koppelung wird mit absoluter Synchronität der Luftaustritt exakt zusammen mit der Warenbewegung hin- und herbewegt und nimmt daher immer die gewünschte Position unterhalb des jeweiligen plattenförmigen Gutes ein.

In Sonderfällen kann angestrebt sein, daß zwar aus den vorgenannten Gründen der Luftaustritt die Warenbewegung mitmacht, daß aber dabei die Strömungsgeschwindigkeit aus Luft und Bad auf der einen Seite des plattenförmigen Gutes stärker sein soll als auf der anderen Seite. Hierzu sind die alternativen Ausführungsmöglichkeiten gemäß Anspruch 9 oder 10 vorgesehen. Der hiermit erzielte Unterschied zwischen der Bad-Luftgeschwindigkeit auf der Vorderseite und der entsprechenden Geschwindigkeit auf der Rückseite bewirkt einen noch größeren Durchsatz an Badflüssigkeit durch die Querbohrungen, da der vorgenannte Geschwindigkeitsunterschied entsprechende Druckdifferenzen zwischen beiden Seiten erzeugt. Dieser größere Flüssigkeitsdurchtritt durch die Querbohrungen ist insbesondere dann von Vorteil, wenn das o.g. Verhältnis Dicke der Leiterplatte zum Durchmesser der Querbohrungen besonders groß ist. Solche Leiterplatten haben dann auch eine genügende "Steifheit", um aufgrund unterschiedlicher Geschwindigkeiten auf ihrer Vorderseite und Rückseite nicht auszubeulen.

Weitere Vorteile und Merkmale der Erfindung sind den weiteren Unteransprüchen sowie der nachstehenden Beschreibung und den dazugehörigen Zeichnungen zu entnehmen. Die Zeichnungen sind auf die Darstellung der für das Verständnis der Erfindung notwendigen Teile beschränkt und im wesentlichen schematisch bzw. prinzipiell. In der im wesentlichen schematischen Zeichnung zeigt:
- Fig. 1:: eine Ausführungsform der Erfindung in der Seitenansicht,
- Fig. 2:: Einzelheiten eines Luftaustrittes einer Lufteinblaseinrichtung,
- Fig. 3:: eine weitere Ausführung des Luftaustrittes einer Lufteinblaseinrichtung,
- Fig. 4:: in der Vorderansicht eine weitere Ausführung der Erfindung mit Traggestellen.
- Fig. 5:: eine weitere Ausführungsform der Erfindung ebenfalls in der Seitenansicht,
- Fig. 6:: eine weitere Ausführungsform der Erfindung ebenfalls in der Seitenansicht,
- Fig. 7:: eine weitere Ausführungsform der Erfindung ebenfalls in der Seitenansicht.

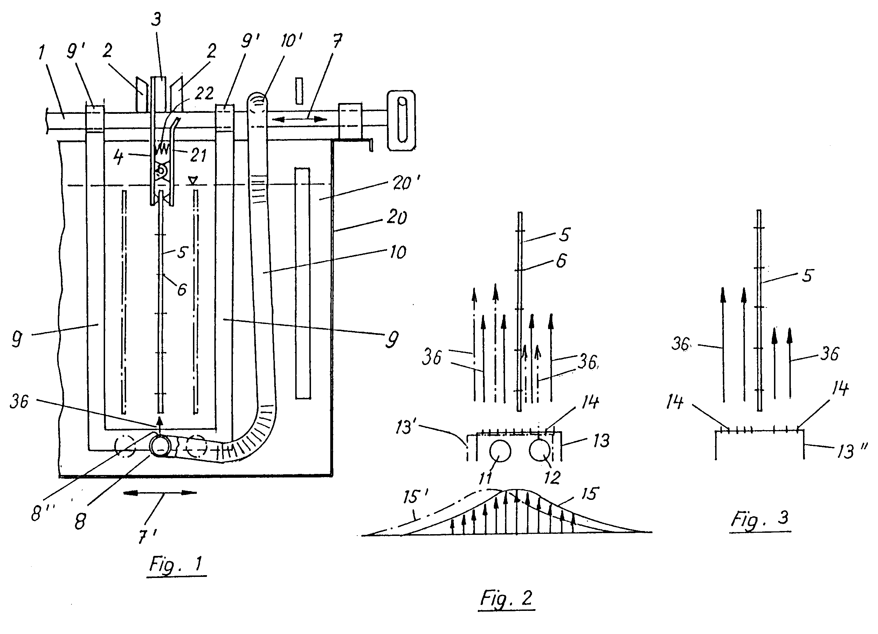

Fig. 1 zeigt eine Schiene 1 mit Einweisungen 2. In diese Einweisungen 2 wird die Schiene 3 des Warenträgers eingelegt, an deren Halterungen 4 der obere Bereich des zu behandelnden plattenförmigen Gutes 5 mittels Klammern 21 unter dem Druck der Klammerfedern 22 lösbar angebracht ist und von dort frei nach unten hängt. Das Gut ist in diesem Ausführungsbeispiel mit Querbohrungen 6 versehen, die senkrecht zu seiner Ebene verlaufen. Der Schiene 1 wird eine hin- und hergehende Warenbewegung gemäß dem Doppelpfeil 7 vermittelt. Die Vorrichtungen zur Erzeugung dieser Warenbewegung sind nicht dargestellt. Diese Warenbewegung hat zur Folge, daß das Gut 5 aus der dargestellten Mittellage im Bad 20 sowohl nach links als auch nach rechts in die jeweils strichpunktierte Position hin- und herbewegt wird.

Ferner ist eine Lufteinblaseinrichtung, hier in Form eines mit Luftaustrittsquerschnitten versehenen Rohres 8, vorgesehen, das sich in der dargestellten Mittellage senkrecht unterhalb des angehängten Gutes 5 befindet. Der Luftaustritt 8' aus dem Rohr 8 verläuft senkrecht nach oben und liegt mit seiner Mitte senkrecht unterhalb des plattenförmigen Gutes 5. Es versteht sich, daß der in Fig. 1 nur prinzipiell angedeutete Luftaustritt 8' und damit die Luftströmung 36 nicht nur an dieser, in der Gutebene gelegenen Stelle, sondern auch beiderseits davon vorgesehen sein kann. Hierzu wird auch auf die Möglichkeiten der Ausgestaltung von Luftaustritten gemäß den anderen Ausführungsbeispielen verwiesen. In einer in Fig. 1 nicht dargestellten Ausführungsform kann zunächst die Luft aus dem Rohr 8 beidseitig einer durch die Rohrmitte gedachten senkrechten Ebene schräg nach unten strömen, wobei auf jeder Seite die Luftströmrichtung mit der vorgenannten gedachten Ebene einen Winkel von etwa 30° haben kann. Anschließend erfolgt (ebenfalls nicht dargestellt) eine Umlenkung der Luftströme zum schematisch dargestellten Luftaustritt 8'. Das Rohr 8 der Lufteinblaseinrichtung und damit auch der Luftaustritt 8' wird, wie mit dem Doppelpfeil 7' angedeutet, synchron zur Warenbewegung der Schiene 1 ebenfalls hin- und herbewegt. Dies kann entweder durch nicht dargestellte, gesonderte Transportmittel erfolgen, die zu denen der Schiene 1 synchron geschaltet sind oder dieser voreilen. Hiermit wird die Zeit ausgeglichen, welche die ausgetretene Luftströmung 36 für den Weg von der Luftblaseinrichtung bis zu ihrem Entlangströmen am Gut benötigt.

In der dargestellten und bevorzugten Ausführungsform der Erfindung geschieht die Bewegung des Luftaustrittes durch eine mechanische Koppelung, z.B. gemäß dem Ausführungsbeispiel in der Weise, daß sich das Rohr 8 an einem Gestänge 9 befindet, das oberseitig (9') fest mit der Schiene 1 verbunden ist, d.h. deren Hin- und Herbewegung lateral gemäß Doppelpfeil 7' mitmacht. Ferner ist eine Luftzuleitung 10 zum Rohr 8 vorgesehen. Diese Luftleitung 10 ist flexibel, da sie gemäß Ziffer 10' fest mit dem nicht beweglichen Teil der Anordnung verbunden ist.

Fig. 2 zeigt eine Lufteinblaseinrichtung, bestehend aus zwei Rohren 11, 12 mit nicht dargestelltem gleichmäßigen, schräg nach unten (siehe vorstehende Erläuterung zur Luftströmung aus dem Rohr 8 in Fig. 1) gerichteten Luftströmung und einer sich darüber befindenden Abdeckung 13 mit einem Luftaustritt in Form von Öffnungen 14. Falls sich die Abdeckung 13 mit symmetrisch über ihre Breite verteilten Luftaustrittsöffnungen 14 mit ihrer Mitte genau senkrecht unter dem Gut 5 befindet, erzeugt sie beiderseits des Gutes 5, d.h. auf dessen Vorderseite und Rückseite, jeweils eine gleich große Strömung 36 aus Luft und Badflüssigkeit. Diese Strömungsverteilung ist unterhalb der Fig. 2 durch eine entsprechende Geschwindigkeitskurve 15 dargestellt. Falls man aber gemäß einem Vorschlag der Erfindung die Abdeckung 13 mit den Luftaustritten 14 einseitig verlagert (siehe strichpunktierte Linie 13'), so hat dies eine entsprechende Verlagerung der Geschwindigkeitskurve zur Folge, die ebenfalls strichpunktiert (15') eingezeichnet ist. Hiermit wird die Geschwindigkeit des Luft-Badgemisches auf der linken Seite des Gutes 5 größer als auf der anderen Seite (siehe auch die strichpunktiert eingezeichneten Pfeile), so daß eine Druckdifferenz und damit eine entsprechende höhere Strömungsgeschwindigkeit des Elektrolytes durch die Bohrungen 6 erzielt wird. Die Lufteinblaseinrichtung 11, 12 macht zusammen mit der Abdeckung 13 aber in beiden Positionen (13 und 13') die Warenbewegung aufgrund der eingangs erläuterten Koppelung mit.

Fig. 3 zeigt eine Abdeckung 13'', die zwar symmetrisch zu dem Gut 5 angeordnet ist, aber auf der linken Seite eine größere Anzahl von Luftaustritten (Bohrungen) 14 aufweist als auf der rechten Seite. Dies hat ebenfalls zur Folge, daß links des Gutes eine höhere Strömungsgeschwindigkeit des Bad-Luftgemisches besteht als auf der rechten Seite.

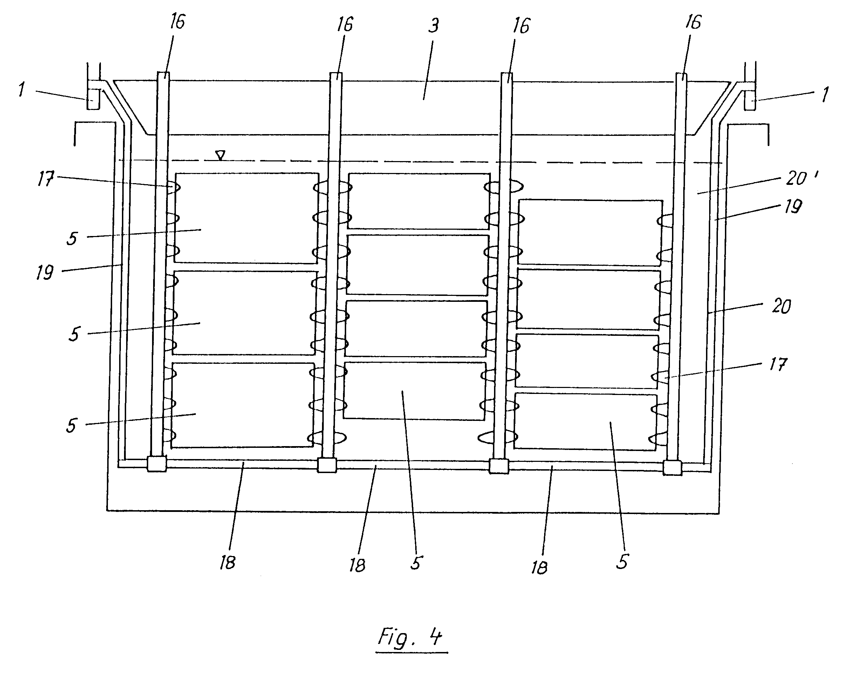

Während bei der Ausführung nach Fig. 1 das Gut 5 in seinem oberen Bereich an Halterungen 4 des Warenträgers 3 angebracht ist und von dort her frei nach unten hängt (derart aufgehängte Platten sind besonders gegen die zum Stand der Technik geschilderten Einflüsse der Strömung der Luft und der Badflüssigkeit empfindlich), zeigt. Fig. 4 eine andere Ausführungsmöglichkeit der Erfindung mit der Schiene 1 und dem Warenträger 3, an dem sich Traggestelle 16 befinden, die nach unten ragen und zwischen sich mittels Federhalterungen oder Klemmschrauben oder dgl. 17 mehrere Platten 5 tragen.

Ein hier nur schematisch angedeutetes Luftzuführrohr 18 ist unterhalb der untersten der senkrecht übereinanderliegenden Platten 5 angeordnet. Dieses Luftzuführrohr besitzt in der Zeichnung nicht gesondert dargestellte Öffnungen, z.B. Bohrungen, welche Gen Luftaustritt bilden. Es verbindet mechanisch die unteren Enden der Traggestelle 16, indem diese unterseitig als sich nach unten öffnende Gabel ausgebildet sind und beim Absenken des Warenträgers zusammen mit der Ware in das im Badbehälter 20 vorgesehene Bad 20' und dabei über das Luftzuführrohr 18 gleiten. Dieses Luftzuführrohr 18 ist ferner über Gestängestreben 19 mit der die Warenbewegung durchführenden Schiene 1 verbunden. Zugleich wird von der Schiene 1 her über die hier nicht dargestellten Einweisungen auch der Warenträger 3 mit den Traggestellen und dem Gut in der Warenbewegung hin- und herbewegt. Die Richtung der Warenbewegung verläuft in Fig. 4 senkrecht zur Zeichenebene. Mit dem Luftzuführrohr 18, den Traggestellen 16 und den Gestängestreben 19 ist ein in sich sehr stabiles, die Warenbewegung durchführendes Gerippe geschaffen. Die Funktion der Strömung aus Luft und Badflüssigkeit und die erzielten Vorteile sind dieselben, wie vorstehend zu den anderen Ausführungsmöglichkeiten geschildert. Die Luftzuführung in das Luftzuführrohr 18 kann dabei über die Gestängestreben 19 erfolgen, an die an ihrem oberen Ende flexible Luftleitungen angeschlossen sind (in der Zeichnung nicht dargestellt).

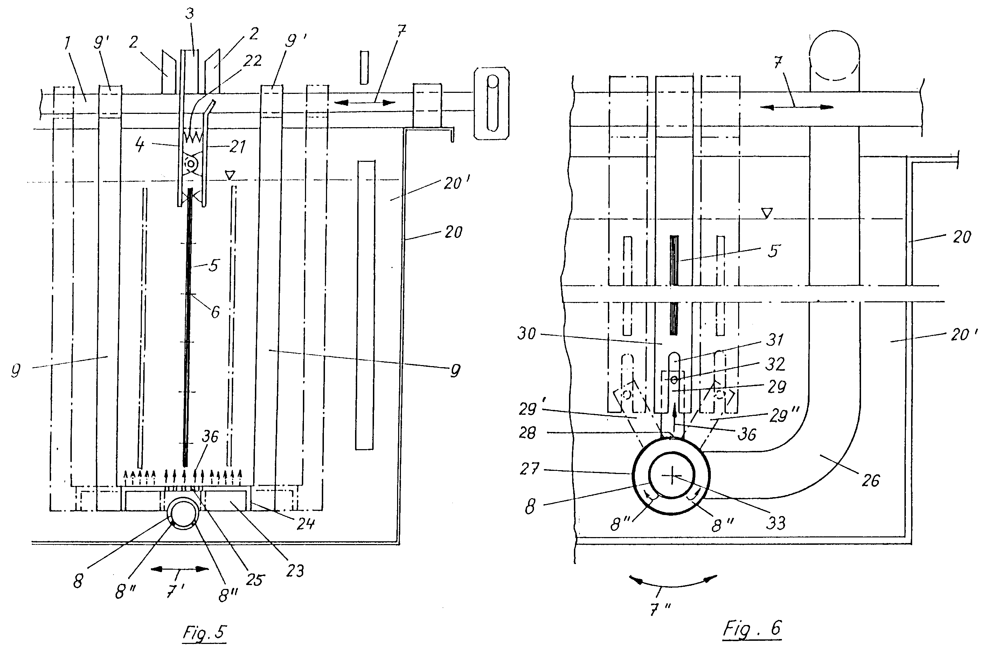

Fig. 5 zeigt eine Ausführungsform der Erfindung, bei der Darstellung und Bezifferung aus Fig. 1 im wesentlichen übernommen wurde. Der Unterschied zur Ausführung nach Fig. 1 besteht darin, daß das Rohr 8 hier nicht beweglich sondern mit der Anordnung, z.B. dem Badbehälter 20 fest verbunden ist. Die Luftausströmung 8'' aus dem Rohr entspricht etwa der zu Fig. 1 erläuterten Luftausströmung im Winkel von 30° zur Senkrechten nach unten. Diese Luftströmung wird nach oben umgelenkt (im einelnen nicht dargestellt) und gelangt in den Raum 23 unterhalb einer weiteren Blende 24, die an ihrer Oberseite mit Luftaustritten in Form von Bohrungen oder Öffnungen 25 versehen ist. Die am Gut 5 entlangstömende Luft ist mit 36 beziffert. Diese weitere Blende 24 ist entweder durch ein gesondertes Transportmittel oder durch mechanische Koppelung mit der Warenbewegung 7 in Richtung des Doppelpfeiles 7' lateral hin- und herbewegbar, wobei diese Hin- und Herbewegung ebenfalls synchron und gleichgerichtet mit der Warenbewegung 7 erfolgt. Diese Anordnung hat den Vorteil daß das die Luft zu den Luftaustritten 25 führende Rohr 8 selber nicht mit bewegt werden muß, sondern fest installiert werden kann nd daß aus diesem Grunde auch die Luftzuleitung zum Rohr 8 fix sein kann, d.h. flexible oder bewegliche Luftzuleitungen sind nicht nötig. Die Hin- und Herbewegung der Blende 24 kann ggfls. auch etwas zur Warenbewegung voreilen. Hierzu wird auf die obigen Ausführungen verwiesen. Generell gilt, daß bei einem der Ausführungsbeispiele dargestellte bzw. erläuterte Merkmale auch sinngemäß bei einem anderen Ausführungsbeispiel vorgesehen sein können.

Auch im Ausführungsbeispiel der Fig. 6 sind das Luftzuführrohr 8 und eine Luftzuleitung 26 fix an der Anordnung angebracht. Die Luftströmung 8'' aus dem Rohr 8 nach unten ist die gleiche, wie anhand der Fig. 5 erläutert. Das Rohr 8 wird hier im Abstand von einem Hüllrohr 27 mit Luftaustritten in Form von Bohrungen oder dergleichen 28 umgeben. Dieses Hüllrohr besitzt einen mit ihm fest verbundenen, in der dargestellten Mittellage nach oben gerichteten Steuerhebel 29. In dieser Position sind die Luftaustritte 28 nach oben gerichtet. Dies entspricht der Mittellage der Hin- und Herbewegung 7' und damit auch der Warenbewegung 7. Mit der Warenbewegung 7 gekoppelt ist ein nach unten ragendes Steuerteil 30, das mit einer Schlitzführung 31 einen Steuernocken 32 des Steuerhebels 29 umfaßt. Synchron zur Warenbewegung wird somit der Steuerhebel 29 in die Positionen 29' nach links und 29'' nach rechts (bezogen auf die Darstellung in Fig. 6) hin und her verschwenkt. Dies hat eine entsprechende Verschwenkung des mit dem Steuerhebel fest verbundenen Hüllrohres 27 um seine Längsachse 33 und damit eine Verlagerung des Luftaustrittes 28 nach links (entsprechend Steuerhebelstellung 29') oder nach rechts (entsprechend Steuerhebelstellung 29'') zur Folge. Dieses Verschwenken der Luftaustritte 28 bewirkt also ebenfalls in Richtung der Warenbewegung eine zur Warenbewegung synchrone und gleichgerichtete Verlagerung der Luftaustritte und damit der Luftströmung 36 entlang des Gutes.

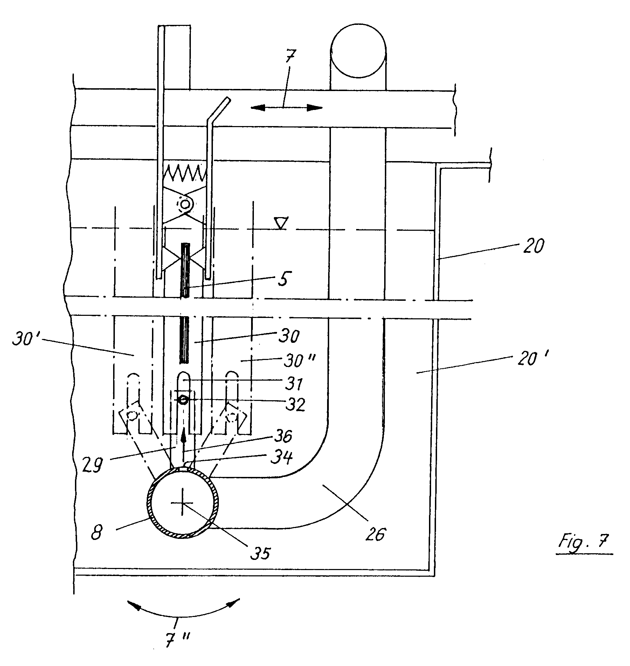

Eine demgegenüber vereinfachte Ausführungsform ist in Fig. 7 dargestellt. Hier ist auf das Hüllrohr verzichtet und nur das Rohr 8 mit einem nach oben gerichteten Luftaustritt 34 vorgesehen. Mit dem Rohr 8 ist ebenfalls fest verbunden ein Steuerhebel 29 vorgesehen, der mit einem Steuernocken 32 in eine senkrechte Führungsnut oder einen senkrechten Führungsschlitz 31 eines Steuerteiles 30 eingreift.

Das erläuterte Steuerteil 30 macht zwar die Warenbewegung 7 mit, hat aber nichts mit dem Halt des Gutes 5 und dessen Bewegung selber zu tun. Die beiderseitigen Positionen des Steuerteiles 30 sind mit 30' und 30'' beziffert. Sie entsprechen den zugehörigen Positionen 29' und 29'' des Steuerelementes.

Die Rohre 8 und 27 vollführen also keine laterale Warenbewegung, sondern werden mittels des Steuerhebels 29 um ihre Längsachse 33 bzw. 35 gemäß Doppelpfeil 7'' im Sinne der Erfindung hin- und her geschwenkt.

## Patentansprüche

1. Verfahren zur Behandlung von plattenförmigen Gut, insbesondere von relativ dünnen, mit Querbohrungen (6) versehenen Leiterplatten (5), in Galvanikanlagen oder dergleichen Anlagen, wobei dem Gut in der Behandlungsflüssigkeit (20') eine hin- und hergehende Warenbewegung (7) erteilt wird und wobei eine Einblasung von Luft in die Behandlungsflüssigkeit (20') vorgesehen ist, deren Luft beiderseits des Gutes nach oben strömt, dadurch gekennzeichnet, daß der Luftaustrittsstrom (36) in die Behandlungsflüssigkeit (20') synchron und gleichgerichtet mit der Warenbewegung (7) hin- und herbewegt (7', 7'') wird.

2. Verfahren nach Anspruch 1, dadurch gekennzeichnet, daß die Hin- und Herverlagerung (7', 7'') des Luftaustrittes der Warenbewegung (7) des Gutes etwas voreilt.

3. Anordnung in Galvanikanlagen oder gleichartigen Anlagen mit einem Warenträger (3), an dem das zu behandelnde, plattenförmige Gut, insbesondere relativ dünne, mit Querbohrungen (6) versehene Leiterplatten (5), lösbar angebracht ist und sich in senkrechter Lage im Behandlungsbad (20') befindet, wobei über den Warenträger dem Gut eine hin- und hergehende Warenbewegung vermittelt wird, deren Bewegungsrichtung (7) senkrecht zur Plattenebene des Gutes verläuft, und wobei unterhalb des jeweiligen Gutes eine Lufteinblaseinrichtung vorgesehen ist derart, daß von Luftaustritten der Lufteinblasung her Luft durch die Behandlungsflüssigkeit beiderseits des Gutes nach oben strömt, zur Durchführung des Verfahrens nach Anspruch 1 oder 2, dadurch gekennzeichnet, daß der Luftaustritt (8', 14, 25, 28, 34) der Lufteinblaseinrichtung (8, 11, 12, 13, 18, 24, 27) mit einer Vorrichtung in Verbindung steht, die ihm eine synchron und gleichgerichtet mit der Warenbewegung (7) verlaufende Hin- und Herbewegung (7'), oder eine hin- und hergehende Verschwenkung (7'') vermittelt.

4. Anordnung nach Anspruch 3, dadurch gekennzeichnet, daß für die Bewegung (7') oder Verschwenkung (7'') des Luftaustrittes (8', 14, 25, 28, 34) der Lufteinblaseinrichtung (8, 11, 12, 13, 18, 24, 27) ein eigener Antrieb vorgesehen ist, wobei der eigene Antrieb für die Bewegung oder Verschwenkung des Luftaustrittes zwar eine der Warenbewegung (7) gleichsinnige Bewegung ausführen, dieser jedoch voreilen kann.

5. Anordnung nach Anspruch 3 oder 4, dadurch gekennzeichnet, daß die Luftaustritte (8', 14, 25, 28, 34) mit der jeweiligen Lufteinblaseinrichtung (8, 11, 12, 13, 18, 24, 27) mechanisch fest gekoppelt sind, oder daß eine Bewegung der Luftaustritte unabhängig von der zugehörigen Lufteinblaseinrichtung gegeben ist.

6. Anordnung nach Anspruch 3, dadurch gekennzeichnet, daß der Luftaustritt (8', 14, 25, 28, 34) mechanisch mit den die Warenbewegung (7) ausführenden Bauteilen gekoppelt ist, wobei eine gegebenenfalls flexible Luftzuleitung (10, 26) von einem ortsfesten Anschluß der Anordnung zur Lufteinblaseinrichtung (8, 11, 12, 13, 18, 24, 27) geführt ist.

7. Anordnung nach Anspruch 6, dadurch gekennzeichnet, daß der Luftaustritt (8', 14, 25, 28, 34) mit einer Schiene (1) mechanisch gekoppelt ist, welche über Einweisungen (2) die Warenträgerschiene (3) hält und ihr die Warenbewegung (7) vermittelt.

8. Anordnung nach einem der Ansprüche 3, 4, 6 oder 7, dadurch gekennzeichnet, daß der Luftaustritt (8', 14, 28, 34) sich in der Mittellage seiner synchron zur Warenbewegung (7) verlaufenden Bewegung oder Verschwenkung (7') genau mittig zur Ebene des darüber befindlichen Gutes (5) befindet.

9. Anordnung nach einem der Ansprüche 3 bis 7, dadurch gekennzeichnet, daß der Luftaustritt (8', 14, 25, 28, 34) in der Mittellage seiner synchron zur Warenbewegung (7) verlaufenden Bewegung (7') oder Verschwenkung (7'') außermittig zu der vom Gut (5) gebildeten Ebene positioniert ist, sich jedoch zumindest mit einem Teil seiner Luftausströmung (36) noch auf der anderen Seite der vom Gut gebildeten Ebene befindet.

10. Anordnung nach einem der Ansprüche 3 bis 9, dadurch gekennzeichnet, daß die Lufteinblaseinrichtung (13'') in der Mittellage ihrer synchron zur Warenbewegung (7) verlaufenden Bewegung (7') zwar symmetrisch zur Ebene des Gutes angeordnet ist, jedoch an einer Seite einen größeren Luftdurchtrittsquerschnitt (14) aufweist als an der anderen Seite.

11. Anordnung nach einem der Ansprüche 3, 4, 6 bis 10, wobei das plattenförmige Gut (5) mit seinen Seitenkanten an senkrecht verlaufenden Traggestellen (16) gehalten ist, die oberseitig am Warenträger (3) befestigt sind, dadurch gekennzeichnet, daß die Lufteinblaseinrichtung (18) die unteren Enden der Traggestelle (16) mechanisch miteinander verbindet.

12. Anordnung nach Anspruch 11, dadurch gekennzeichnet, daß die Traggestelle (16) an ihrem unteren Ende als sich nach unten öffnende Gabeln ausgebildet sind und mit diesen gabelartigen Öffnungen von oben über die Lufteinblaseinrichtung (18) greifen.

13. Anordnung nach Anspruch 11 oder 12, dadurch gekennzeichnet, daß die Lufteinblaseinrichtung (18) außerdem über Gestängestreben (19) mit der die Warenbewegung ausführenden Schiene (1) fest verbunden ist.

14. Anordnung nach Anspruch 13, dadurch gekennzeichnet, daß die Luftzuführung über die Gestängestreben (19) zur Lufteinblaseinrichtung (18) erfolgt, wobei die Gestängestreben (19) oberseitig an flexible Leitungen angeschlossen sind.

15. Anordnung nach einem der Ansprüche 3 bis 14, dadurch gekennzeichnet, daß eine Lufteinblaseinrichtung (8) fest am Badbehälter (20) angebracht ist und daß eine Verstellung des Luftaustrittes (25, 28, 34) vorgesehen ist, die synchron und gleichgerichtet mit der Warenbewegung erfolgt.

16. Anordnung nach Anspruch 15, gekennzeichnet durch ein fest mit dem Badbehälter verbundenes Luftzuführrohr (8) und eine darüber angeordnete, den Luftaustritt (25) aufweisende Blende (24), wobei die Blende synchron und gleichgerichtet zur Warenbewegung (7) hin und her bewegt (7') wird.

17. Anordnung nach Anspruch 15, gekennzeichnet durch ein fest mit dem Badbehälter (20) verbundenes Luftzuführrohr (8) und durch ein das Luftzuführrohr mit Abstand umgebendes Hüllrohr (27), wobei das Hüllrohr den Luftaustritt (28) aufweist und synchron sowie gleichgerichtet zur Warenbewegung (7) um seine Längsachse (33) hin- und her drehbar ist.

18. Anordnung nach einem der Ansprüche 3 bis 17, dadurch gekennzeichnet, daß das Luftzuführrohr (8, 18) eine Luftausströmung (8'') aufweist, die beiderseits einer senkrechten Ebene im Winkel dazu verlaufend nach unten gerichtet ist.

19. Anordnung nach Anspruch 15, gekennzeichnet durch ein Luftzuführrohr (8) mit einem oberseitigen Luftaustritt (34), wobei das Luftzuführrohr gegen eine Lateralbewegung am Badbehälter (20) fest gelagert, jedoch um seine Längsachse (35) synchron und gleichgerichtet zur Warenbewegung (7) hin und her drehbar ist.

20. Anordnung nach Anspruch 17 oder 19, dadurch gekennzeichnet, daß am Luftzuführrohr (8) oder am Hüllrohr (27) ein senkrecht zum Rohr verlaufender Steuerhebel (29) fest angebracht ist und daß am Steuerhebel angreifende, ihn entsprechend der Warenbewegung (7) verschwenkende (7'') Steuerelemente vorgesehen sind.

21. Anordnung nach Anspruch 20, dadurch gekennzeichnet, daß der Steuerhebel (29) als Schwenkhebel mit Steuernocken (32) in eine senkrechte Schlitzführung (31) eines mit der Warenbewegung gekoppelten und dieses mit durchführenden Steuerteiles (30) eingreift.

## Claims

1. Method of treating plate-shaped material, particularly thin printed circuit boards (5) provided with transverse bores (6), in galvanising installations or installations for electrolytic treatment, the material having imparted thereto in the treatment liquor (20') a to-and-fro movement of the material (7), and an insufflation of air being provided into the treatment liquor (20'), the air from which flows upwards on both sides of the material, characterised in that the air outlet flow (36) into the treatment liquor (20') is moved to and fro (7', 7'') synchronously with and in the same direction as the movement (7) of the material.

2. Method according to claim 1, characterised in that the to-and-fro displacement (7', 7'') of the air outlet is slightly in advance of the movement (7) of the material.

3. Device in galvanic installations or installations for electrolytic treatment with a material carrier (3) to which the plate-shaped material to be treated, particularly relatively thin printed circuit boards (5) provided with transverse bores (6) is detachably secured, and is located in a vertical position in the treatment bath (20'), there being imparted to the material via the material carrier a to-and-fro movement whose direction extends perpendicularly to the plane of the plates of material, an air insufflation device being provided beneath the respective material, in such a way that air flows in an upward direction from air outlets of the air insufflation system on both sides of the material, in order to carry out the method according to claim 1 or 2, characterised in that the air outlet (8', 14, 25, 28, 34) of the air insufflation device (8, 11, 12, 13, 18, 24, 27) communicates with a device which imparts to it a to-and-fro movement (7') synchronous with and acting in the same direction as the movement (7) of the material, or a to-and-fro pivoting movement (7'').

4. Device according to claim 3, characterised in that the movement (7') or pivoting (7'') of the air outlet (8', 14, 25, 28, 34) of the air insufflation device (8, 11, 12, 13, 18, 24, 27) is provided with its own drive, the specific drive for the movement or pivoting of the air outlet in fact executing a movement in the same direction as that of the movement (7) of the material, but being capable of being in advance thereof.

5. Device according to claim 3 or 4, characterised in that the air outlets (8', 14, 25, 28, 34) are mechanically securely coupled to the respective air insufflation device (8, 11, 12, 13, 18, 24, 27), or in that a movement of the air outlets is provided which is independent of the associated air insufflation device.

6. Device according to claim 3, characterised in that the air outlet (8', 14, 25, 28, 34) is mechanically coupled with the components carrying out the movement (7) of the material, an air feed pipe (10, 26), if necessary flexible, being led from a stationary connection of the device to the air insufflation device (8, 11, 12, 13, 18, 24, 27).

7. Device according to claim 6, characterised in that the air outlet (8', 14, 25, 28, 34) is mechanically coupled with a bar (1) which carries via guides (2) the material carrier bar (3), and imparts thereto the movement (7) of the material.

8. Device according to one of claims 3, 4, 6 or 7, characterised in that the air outlet (8', 14, 28, 34), in the central position of its movement or pivoting (7') synchronous with the movement (7) of the material, is precisely central to the plane of the material (5) located thereabove.

9. Device according to one of claims 3 to 7, characterised in that the air outlet (8', 14, 25, 28, 34), in the central position of its movement (7') or pivoting (7'') synchronous with the movement (7) of the material, is positioned off-centre from the plane formed by the material (5), yet is located, with at least a portion of its air outflow (36), still on the other side of the plane formed by the material (5).

10. Device according to one of claims 3 to 9, characterised in that the air insufflation device (13''), in the central position of its movement (7') synchronous with the movement (7) of the material, is in fact disposed symmetrically with the plane of the material, yet has on one side a larger air-passage cross-section (14) than on the other side.

11. Device according to one of claims 3, 4, 6 to 10, the plate-shaped material (5) being secured by its lateral edges on vertically-extending support frames (16) which are attached on the upper side of the material carrier (3), characterised in that the air insufflation device (18) mechanically interconnects the lower ends of the support frames (16).

12. Device according to claim 11, characterised in that the support frames (16) are designed at their lower end as downwardly-opening forks, and engage with these fork-like openings from above, over the air insufflation device (18).

13. Device according to claim 11 or 12, characterised in that the air insufflation device (18) is in addition securely connected by linkage bars (19) to the bar (1) executing the movement of the material.

14. Device according to claim 13, characterised in that the air is supplied via the linkage bars (19) to the air insufflation device (18), the linkage bars (19) being connected at the top to flexible pipes.

15. Device according to one of claims 3 to 14, characterised in that an air insufflation device (8) is securely attached to the bath container (20), and in that a displacement of the air outlet (25, 28, 34) is provided which is effected synchronously with and in the same direction as the movement of the material.

16. Device according to claim 15, characterised by an air feed tube (8), securely attached to the bath container, and, located thereabove, a baffle (24) containing the air outlet (25), the baffle moving to and fro synchronously with and in the same direction as the movement (7) of the material.

17. Device according to claim 15, characterised by an air feed tube (8) securely connected to the bath container (20), and by a sleeve tube (27) which surrounds the air feed tube at a certain distance, the sleeve tube including the air outlet (28) and being rotatable to and fro about its longitudinal axis (33) synchronously with and in the same direction as the movement (7) of the material.

18. Device according to one of claims 3 to 17, characterised in that the air feed tube (8, 18) has an air outflow (8'') which is oriented downwards, on both sides of a vertical plane and at an angle thereto.

19. Device according to claim 15, characterised by an air feed tube (8) with an air outlet (34) at the top, the said air feed tube being mounted on the bath container (20) so as to be secured against any lateral movement, yet being rotatable about its longitudinal axis (35) synchronously with and in the same direction as the movement (7) of the material.

20. Device according to claim 17 or 19, characterised in that a control lever (29) is securely attached to the air feed tube (8) or to the sleeve tube (27) and extends vertically to the tube, and in that control members are provided, engaging on the control lever and pivoting it (7'') in accordance with the movement (7) of the material.

21. Device according to claim 20, characterised in that the control lever (29), as a pivot lever, engages with control cams (32) in a vertical slot guide (31) of a control portion (30) coupled to the movement of the material and carrying out this movement along with it.

## Revendications

1. Procédé de traitement d'articles en forme de plaques, en particulier de cartes imprimées (5) relativement fines, pourvues de trous transversaux (6), dans des installations de galvanisation ou des installations de traitement électrolytique, l'article subissant dans le liquide de traitement (20') un déplacement (7) en va et vient, une injection d'air dans le liquide de traitement (20') étant prévue, dans laquelle l'air forme un courant ascendant de part et d'autre de l'article, caractérisé en ce que le flux d'air (36) arrivant dans le liquide de traitement (20') subit un déplacement en va et vient (7', 7'') synchrone et d'orientation identique au déplacement de pièces (7).

2. Procédé selon la revendication 1, caractérisé en ce que la translation (7', 7'') en va et vient du jet d'air précède quelque peu le déplacement (7) de l'article.

3. Dispositif pour installations de galvanisation ou installations de traitement électrolytique comportant un support de pièces (3), sur lequel l'article à traiter en forme de plaque, en particulier des cartes imprimées (5) relativement minces, pourvues de trous transversaux (6), est monté de manière amovible, et se situe en position verticale dans le bain de traitement (20'), l'article subissant par l'intermédiaire du support de pièces un déplacement en va et vient, dont le sens (7) est perpendiculaire au plan de l'article, et un dispositif d'injection d'air prévu sous l'article considéré, pour que de l'air provenant de buses d'air du dispositif d'injection d'air forme de part et d'autre de l'article un courant ascendant à travers le liquide de traitement, afin de mettre en oeuvre le procédé selon la revendication 1 ou la revendication 2,
caractérisé en ce que la buse d'air (8', 14, 25, 28, 34) du dispositif d'injection d'air (8, 11, 12, 13, 18, 24, 27) est en liaison avec un dispositif, par l'intermédiaire duquel il subit un déplacement en va et vient (7') ou un pivotement en va et vient (7'') synchrone et d'orientation identique au déplacement de pièces (7).

4. Dispositif selon la revendication 3, caractérisé en ce qu'un moteur spécifique est prévu pour le déplacement (7') ou le pivotement (7'') de la buse d'air (8', 14, 25, 28, 34) du dispositif d'injection d'air (8, 11, 12, 13, 18, 24, 27), le moteur spécifique pouvant, en vue du déplacement ou pivotement de la buse d'air, induire un déplacement d'une orientation certes identique à celle du déplacement de pièces (7) mais précédant toutefois ce dernier.

5. Dispositif selon la revendication 3 ou 4, caractérisé en ce que les buses d'air (8', 14, 25, 28, 34) sont couplées mécaniquement de manière fixe au dispositif d'injection d'air (8, 11, 12, 13, 18, 24, 27) correspondant, ou en ce qu'un déplacement des buses d'air s'opère indépendamment du dispositif d'injection d'air correspondant.

6. Dispositif selon la revendication 3, caractérisé en ce que la buse d'air (8', 14, 25, 28, 34) est couplée mécaniquement aux organes assurant le déplacement de pièces (7), une arrivée d'air (10, 26) le cas échéant flexible reliant un raccord fixe du système au dispositif d'injection d'air (8, 11, 12, 13, 18, 24, 27).

7. Dispositif selon la revendication 6, caractérisé en ce que la buse d'air (8', 14, 25, 28, 34) est couplée mécaniquement à un rail (1), qui maintient par des pièces (2) le rail (3) du support de pièces et lui fait subir le déplacement de pièces (7).

8. Dispositif selon l'une quelconque des revendications 3, 4 et 6 ou 7, caractérisé en ce que, lorsqu'elle est à mi-parcours de son déplacement ou pivotement (7') synchrone au déplacement de pièces (7) la buse d'air (8', 14, 28, 34), se situe précisément en position médiane par rapport au plan de l'article (5) situé au-dessus.

9. Dispositif selon l'une des revendications 3 à 7, caractérisé en ce que lorsqu'elle est à mi-parcours de son déplacement (7') ou pivotement (7'') synchrone au déplacement de pièces (7) la buse d'air (8', 14, 25, 28, 34) ne se situe pas en position médiane par rapport au plan formé par l'article (5), mais toutefois se situe encore de l'autre côté du plan formé par l'article, par l'intermédiaire d'une partie de son flux d'air (36).

10. Dispositif selon l'une des revendications 3 à 9, caractérisé en ce que lorsqu'il est à mi-parcours de son déplacement (7') synchrone au déplacement de pièces (7) le dispositif d'injection d'air (13'') occupe une position symétrique par rapport au plan de l'article, mais présente sur un côté une section de passage d'air (14) plus grande que sur l'autre côté.

11. Dispositif selon l'une des revendications 3, 4, 6 à 10, dans lequel l'article (5) en forme de plaque est maintenu par ses arêtes latérales sur des structures de support (16) s'étendant verticalement, qui sont fixées en partie supérieure sur le support de pièces (3),
caractérisé en ce que le dispositif d'injection d'air (18) relie mécaniquement l'une à l'autre les extrémités inférieures des structures de support (16).

12. Dispositif selon la revendication 11, caractérisé en ce que les structures de support (16) sont conformées à leur extrémité inférieure comme des fourches ouvertes vers le bas et en ce qu'elles viennent en prise, par le dessus, avec le dispositif d'injection d'air (18), grâce à ces ouvertures du type de fourches.

13. Dispositif selon la revendication 11 ou la revendication 12, caractérisé en ce que le dispositif d'injection d'air (18) est par ailleurs assemblé fixement au rail (1) exécutant le déplacement de pièces, par l'intermédiaire de tiges transversales (19).

14. Dispositif selon la revendication 13, caractérisé en ce que l'acheminement de l'air vers le dispositif d'injection d'air (18) est assuré par les tiges transversales (19), les tiges transversales (19) étant raccordées en partie haute à des tuyauteries flexibles.

15. Dispositif selon l'une des revendications 3 à 14, caractérisé en ce que le dispositif d'injection (18) est monté de manière fixe sur la cuve (20) et en ce qu'une translation de la buse d'air (25, 28, 34) est prévue et s'opère de manière synchrone et dans la même orientation que le déplacement de pièces.

16. Dispositif selon la revendication 15, caractérisé par une tubulure d'amenée d'air (8) reliée à la cuve (20) ainsi que par un écran (24) situé au-dessus et comportant la buse d'air (25), l'écran subissant un déplacement (7') en va et vient synchrone et d'orientation identique au déplacement de pièces (7).

17. Dispositif selon la revendication 15, caractérisé par une tubulure d'amenée d'air (8) reliée fixement à la cuve (20) et par une gaine (27) entourant la tubulure d'amenée d'air selon un certain espacement, la gaine comportant la buse d'air (28) et étant capable de rotation par rapport à son axe longitudinal (33) selon un déplacement en va et vient synchrone et d'orientation identique au déplacement de pièces (7).

18. Dispositif selon l'une des revendication 3 à 17, caractérisé en ce que la tubulure d'amenée d'air (8, 18) présente une sortie d'air (8'') qui est orientée vers le bas, de part et d'autre d'un plan vertical, en formant un angle par rapport audit plan.

19. Dispositif selon la revendication 15, caractérisé par une tubulure d'amenée d'air (8) comportant une buse d'air (34) supérieure, la tubulure d'amenée d'air étant supportée de manière fixe dans le but d'éviter tout déplacement latéral sur la cuve (20), tout en étant capable de rotation selon son axe longitudinal (35) de manière synchrone et dans une direction identique au déplacement de pièces (7).

20. Dispositif selon la revendication 17 ou 19, caractérisé en ce que en ce qu'un levier de commande (29) s'étendant perpendiculairement à la tubulure, est monté de manière fixe sur la tubulure d'amenée d'air (8) ou sur la gaine (27), et en ce que des éléments de commande, faisant pivoter (7'') le levier en fonction du déplacement de pièces (7), sont prévus.

21. Dispositif selon la revendication 20, caractérisé en ce que le levier de commande (29), en tant que levier pivotant, vient en prise par des cames de commande (32) dans un élément de guidage en forme de fente (31) verticale d'une pièce de commande (30) couplée au déplacement de pièces et effectuant également ce déplacement.
